(19) Europäisches Patentamt
European Patent Office
Office européen des brevets

(11) **EP 4 096 370 A1**

(12) **EUROPEAN PATENT APPLICATION**

(43) Date of publication:
**30.11.2022 Bulletin 2022/48**

(21) Application number: **22174581.3**

(22) Date of filing: **20.05.2022**

(51) International Patent Classification (IPC):
**H05K 1/03** $^{(2006.01)}$    **H05K 1/11** $^{(2006.01)}$
**H05K 3/46** $^{(2006.01)}$    **H05K 3/00** $^{(2006.01)}$
**H05K 3/18** $^{(2006.01)}$    **H05K 3/42** $^{(2006.01)}$

(52) Cooperative Patent Classification (CPC):
**H05K 3/4655; H05K 1/034; H05K 1/115;**
H05K 3/002; H05K 3/0035; H05K 3/181;
H05K 3/429; H05K 2201/0116; H05K 2201/0141;
H05K 2201/0154; H05K 2201/09509;
H05K 2201/09563; H05K 2201/096;
H05K 2201/09736; H05K 2201/09827

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **28.05.2021 JP 2021089752
12.11.2021 JP 2021184613**

(71) Applicant: **Nitto Denko Corporation
Ibaraki-shi
Osaka 567-8680 (JP)**

(72) Inventors:
• **MATSUTOMI, Akihito
Ibaraki-shi, Osaka, 567-8680 (JP)**
• **SAWASHI, Kanayo
Ibaraki-shi, Osaka, 567-8680 (JP)**

(74) Representative: **Hoffmann Eitle
Patent- und Rechtsanwälte PartmbB
Arabellastraße 30
81925 München (DE)**

(54) **WIRING CIRCUIT BOARD AND METHOD OF PRODUCING THE SAME**

(57) A wiring circuit board 1 includes a porous insulating layer 2, and a first conductive layer 31 sequentially toward one side in the thickness direction. The first conductive layer 31 includes a first signal wire 34 and first ground wires 35. Each of the first ground wires 35 is thicker than the first signal wire 34.

FIG. 1

EP 4 096 370 A1

**Description**

BACKGROUND ART

The present invention relates to a wiring circuit board and a method of producing the wiring circuit board.
Wiring circuit boards each including a conductive layer and a wiring circuit board are known (for example, see Patent document 1 below). The wiring circuit board described in Patent document 1 includes a conductive layer having a plurality of wires. The wire portions of Patent document 1 are the same in thickness.

Citation List

Patent Document

Patent Document 1: Japanese Unexamined Patent Publication No. 2019-123851

SUMMARY OF THE INVENTION

PROBLEM TO BE SOLVED BY THE INVENTION

The wiring circuit board may be pressed in a thickness direction depending on the use and purpose. In such a case, the press uniformly changes the thickness of several parts of the porous insulating resin film that overlap the wire portions. Consequently, the uniform change in the thickness causes a disadvantage that the electric properties of the wires uniformly change.
The present invention provides a wiring circuit board in which the change in the electric properties of the first wiring portion can be suppressed more than the change in the electric properties of the second wiring portion, and a method of producing the wiring circuit board.

MEANS FOR SOLVING THE PROBLEM

The present invention [1] includes a wiring circuit board comprising a porous insulating layer and a conductive layer sequentially toward one side in a thickness direction, wherein the conductive layer has a first wiring portion and a second wiring portion thicker than the first wiring portion.
The wiring circuit board includes the second wiring portion thicker than the first wiring portion. In other words, the first wiring portion is thinner than the second wiring portion.
Thus, when the wiring circuit board is pressed in the thickness direction, the porous insulating layer overlapping the first wiring portion in the thickness direction receives a lower pressure than the porous insulating layer overlapping the second wiring portion in the thickness direction does. This can suppress the change in the thickness of the porous insulating layer overlapping the first wiring portion in the thickness direction more than the change in the thickness of the porous insulating layer overlapping the second wiring portion in the thickness direction.
As a result, the change in the electric properties of the first wiring portion can be suppressed more than the change in the electric properties of the second wiring portion.
The present invention [2] includes the wiring circuit board in [1], wherein two of the second wiring portions are disposed and separated from each other by an interval in a direction orthogonal to the thickness direction, and the first wiring portion is disposed between the second wiring portions.
When the wiring circuit board is pressed, the porous insulating layer that overlaps the two second wiring portions in the thickness direction can receive a high pressure while keeping the balance between the pressures on the two overlapping parts. Thus, the porous insulating layer that overlaps the first wiring portion disposed between the two second wiring portions receives a lower pressure. This can suppress the change in the thickness of the porous insulating layer overlapping the first wiring portion in the thickness direction more than the change in the thickness of the porous insulating layer overlapping each of the second wiring portions in the thickness direction.
The present invention [3] includes the wiring circuit board described in [1] or [2], further comprising a ground layer disposed on the other surface in the thickness direction of the porous insulating layer, wherein the ground layer has a third wiring portion and a fourth wiring portion, the third wiring portion overlaps the first wiring portion and the fourth wiring portion overlaps the second wiring portion when being projected in the thickness direction, and the fourth wiring portion is thicker than the third wiring portion.
In the wiring circuit board, the ground layer includes the third wiring portion, which overlaps the first wiring portion, and the fourth wiring portions, which overlap the second wiring portions and are thicker than the third wiring portion. Thus, when the wiring circuit board is pressed in the thickness direction, the porous insulating layer overlapping the first wiring portion in the thickness direction receives a lower pressure than the porous insulating layer overlapping each of the second wiring portions in the thickness direction does. This can suppress the change in the thickness of the porous insulating layer overlapping the first wiring portion in the thickness direction more than the change in the thickness of the porous insulating layer overlapping each of the second wiring portions in the thickness direction.

The present invention [4] includes the wiring circuit board described in described in [3], wherein the porous insulating layer has a penetrating hole penetrating the porous insulating layer in the thickness direction, and the wiring circuit board further comprises a conductor connecting portion filling the penetrating hole and being in contact with the conductive layer and the ground layer.

The present invention [5] includes the wiring circuit board described in described in any one of [1] to [4], further comprising: an adhesive layer; and an insulating cover layer, wherein the insulating cover layer covers the conductive layer and the porous insulating layer through the adhesive layer from one side in the thickness direction.

The present invention [6] includes a method of producing a wiring circuit board, the method comprising: a first step of disposing a conductive layer on one surface in a thickness direction of a porous insulating layer, wherein the conductive layer includes a first wiring portion and a second wiring portion thicker than the first wiring portion; and a second step of pressing the insulating cover layer through an adhesive layer to the conductive layer and the porous insulating layer.

Even when the insulating cover layer is pressed to the conductive layer and the porous insulating layer through the adhesive layer and a high pressure is applied on the porous insulating layer in the second step, the method of the present invention can suppress the change in the thickness of the porous insulating layer overlapping the first wiring portion in the thickness direction more than the change in the thickness of the porous insulating layer overlapping the second wiring portion in the thickness direction. As a result, the change in the electric properties of the first wiring portion can be suppressed more than the change in the electric properties of the second wiring portion.

EFFECTS OF THE INVENTION

By using the wiring circuit board of the present invention and the method of producing the wiring circuit board, the change in the electric properties of the first wiring portion can be suppressed more than the change in the electric properties of the second wiring portion.

BRIEF DESCRIPTION OF THE DRAWINGS

[FIG. 1] FIG. 1 is a cross-sectional view of one embodiment of the present invention.
[FIG. 2] FIG. 2A to FIG. 2D illustrate the steps of producing the wiring circuit board of FIG. 1.
FIG. 2A illustrates a step for preparing a first porous laminate. FIG. 2B illustrates a step for forming a first via. FIG. 2C illustrates a step for forming a first plated layer. FIG. 2D illustrates a step for patterning a second conductive layer.
[FIG. 3] Subsequently to FIG. 2D, FIG. 3A to FIG. 3C illustrate the steps of producing the wiring circuit board. FIG. 3A illustrates a step of bonding a second porous laminate to the second conductive layer. FIG. 3B illustrates a step of forming a second via and a third via.
FIG. 3C illustrates a step of forming a second plated layer.
[FIG. 4] Subsequently to FIG. 3C, FIG. 4A and FIG. 4B illustrate the steps of producing the wiring circuit board. FIG. 4A illustrates a step of patterning a first plated layer and a first underlying layer. FIG. 4B illustrates a step of bonding the first cover laminate and the second cover laminate together.
[FIG. 5] FIG. 5 is a cross-sectional view of a variation of the wiring circuit board.
[FIG. 6] FIG. 6 is a cross-sectional view of a variation of the wiring circuit board.
[FIG. 7] FIG. 7 is a cross-sectional view of a variation of the wiring circuit board.

DESCRIPTION OF THE EMBODIMENT

1. One Embodiment of Wiring Circuit Board

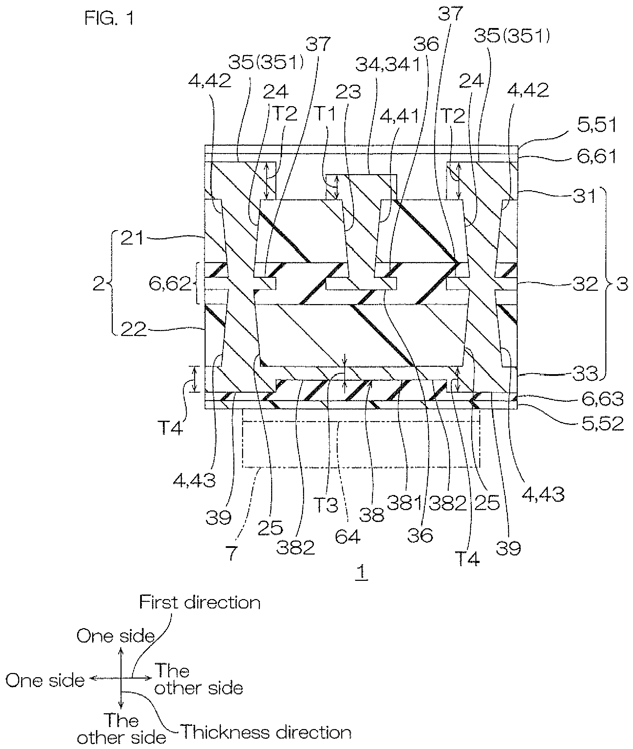

One embodiment of the wiring circuit board of the present invention is described with reference to FIG. 1.

A wiring circuit board 1 has a thickness. The wiring circuit board 1 extends in a surface direction. The surface direction is orthogonal to a thickness direction. The wiring circuit board 1 has an appropriately flat board shape.

The wiring circuit board 1 includes a porous insulating layer 2 and a conductive layer 3 sequentially in the thickness direction. The porous insulating layer 2 includes a first porous insulating layer 21 and a second porous insulating layer 22 sequentially in the thickness direction. The conductive layer 3 includes a first conductive layer 31, a second conductive layer 32, and a third conductive layer 33 sequentially in the thickness direction. Specifically, the wiring circuit board 1 includes the third conductive layer 33, the second porous insulating layer 22, the second conductive layer 32, the first porous insulating layer 21, and the first conductive layer 31 toward one side in the thickness direction. The wiring circuit board 1 further includes a conductor connecting portion 4, an insulating cover layer 5, and an adhesive layer 6.

2. Porous Insulating Layer 2

The porous insulating layer 2 includes the first porous insulating layer 21 and the second porous insulating layer 22 toward the other side in the thickness direction.

2.1 First Porous Insulating Layer 21

The first porous insulating layer 21 has a thickness. The first porous insulating layer 21 extends in the surface direction. The first porous insulating layer 21 has an appropriately flat board shape. The first porous insulating layer 21 includes a first penetrating hole 23 and two second penetrating holes 24.

The first penetrating hole 23 is disposed at an intermediate portion of the first porous insulating layer 21 in a first direction. The first direction is included in the surface direction.

One of the second penetrating holes 24 is disposed at one side of the first penetrating hole 23 in the first direction, holding an interval therebetween. The other second penetrating hole 24 is disposed at the other side of the first penetrating hole 23 in the first direction, holding an interval therebetween. The other second penetrating hole 24 is disposed across the first penetrating hole 23 from the one second penetrating hole 24 in the first direction. In this manner, the one second penetrating hole 24, the first penetrating hole 23, and the other second penetrating hole 24 are arranged sequentially in the first direction. In other words, the first penetrating hole 23 is disposed between the two second penetrating holes 24.

The first penetrating hole 23 and the two second penetrating holes 24 penetrate the first porous insulating layer 21 in the thickness direction. Inner peripheral surfaces of the first porous insulating layer 21 go along the thickness direction and define the first penetrating hole 23 and the two second penetrating holes 24, respectively. The inner peripheral surfaces each may have a tapered shape having a cross-sectional area gradually increasing toward one side in the thickness direction.

2.2 Second Porous Insulating Layer 22

The second porous insulating layer 22 is disposed at the other side of the first porous insulating layer 21 in the thickness direction. The second porous insulating layer 22 is separated from the first porous insulating layer 21 by an interval in the thickness direction. The second porous insulating layer 22 is bonded to the first porous insulating layer 21 through a second adhesive layer 62 that is described below.

The second porous insulating layer 22 has a thickness. The second porous insulating layer 22 extends in the surface direction. The second porous insulating layer 22 has an appropriately flat board shape. The second porous insulating layer 22 has two third penetrating holes 25.

When being projected in the thickness direction, the two third penetrating holes 25 overlap the two second penetrating holes 24, respectively. The two third penetrating holes 25 are next to each other in the first direction, holding an interval therebetween.

The two third penetrating holes 25 penetrate the second porous insulating layer 22 in the thickness direction. Inner peripheral surfaces of the second porous insulating layer 22 go along the thickness direction and define the two third penetrating holes 25, respectively. The inner peripheral surfaces each may have a tapered shape having a cross-sectional area gradually increasing toward the other side in the thickness direction.

2.3 Material of Porous Insulating Layer 2

Examples of the material of the porous insulating layer 2 include resin. The resin is not especially limited. Examples of the resin include polycarbonate resin, polyimide resin, polyimide fluoride resin, epoxy resin, phenol resin, urea resin, melamine resin, diallyl phthalate resin, silicone resin, thermosetting urethane resin, fluorine resin, and a liquid crystal polymer. Preferably, a polyimide resin and a liquid crystal polymer are used.

2.4 Properties of Porous Insulating Layer 2

The porous insulating layer 2 is porous. The porous insulating layer 2 has a closed cell and/or an opened cell.

The porous insulating layer 2 has a porosity of, for example, 50% or more, preferably 60% or more, more preferably 70% or more, even more preferably 80% or more. The porous insulating layer 2 has a porosity of, for example, less than 100%, and 99% or less. When the material of the porous insulating layer 2 is a polyimide resin, the porosity of the porous insulating layer 2 is obtained by a calculation using the following formula.

$$\text{Permittivity of Porous Insulating Layer 2} = \text{Permittivity of Air} \times \text{Porosity} + \text{Permittivity}$$

$$\text{of Polyimide} \times (1 - \text{Porosity})$$

Here, the permittivity of the air is 1, and the permittivity of the polyimide resin is 3.5. Thus, the following formulas hold.

$$\text{Permittivity of Porous Insulating Layer 2} = \text{Porosity} + 3.5(1 - \text{Porosity})$$

$$\text{Porosity} (\%) = [(3.5 - \text{Permittivity of Porous Insulating Layer 2})/2.5] \times 100$$

The porous insulating layer 2 has a permittivity of, for example, 2.5 or less, preferably 1.9 or less, more preferably 1.6 or less, and, for example, more than 1.0 at a frequency of 60 GHz. The permittivity of the porous insulating layer 2 is measured by a resonator method using a frequency of 60 GHz.
The dielectric loss tangent of the porous insulating layer 2 at a frequency of 60 GHz is, for example, 0.006 or less, and, for example, more than 0. The dielectric loss tangent of the porous insulating layer 2 is measured by a resonator method using a frequency of 60 GHz.

3. Conductive Layer 3

The conductive layer 3 extends in a second direction. The second direction intersects with the thickness direction and the first direction. Specifically, the second direction is orthogonal to the thickness direction and the first direction.
The conductive layer 3 includes the first conductive layer 31, the second conductive layer 32, and the third conductive layer 33 sequentially toward the other side in the thickness direction.

3.1 First Conductive Layer 31

The first conductive layer 31 is disposed at one side in the thickness direction of the first porous insulating layer 21. Specifically, the first conductive layer 31 is disposed on one surface in the thickness direction of the first porous insulating layer 21. The first conductive layer 31 has a first signal wire 34 which exemplifies a first wiring portion and two first ground wires 35 which exemplify two second wiring portions.

3.1.1 First Signal Wire 34

The first signal wire 34 transmits a signal in the second direction. Examples of the signal include differential signals. The signal includes a low current of, for example, less than 1A, and less than 0.1A. The first signal wire 34 is disposed at an intermediate portion of the first conductive layer 31 in the first direction. The first signal wire 34 is disposed at one side in the thickness direction of the first penetrating hole 23. The first signal wire 34 closes one end in the thickness direction of the first penetrating hole 23. The first signal wire 34 is in contact with one surface in the thickness direction of the first porous insulating layer 21 around the first penetrating hole 23. The first signal wire 34 includes a signal terminal 341. The signal terminal 341 is disposed at an end in the second direction of the first signal wire 34. The signal terminal 341 is connected to an electrode of an outer board not illustrated.
The first signal wire 34 is thinner than each of the first ground wires 35 described next. Specifically, the first signal wire 34 has a thickness T1 of, for example, 50 $\mu$m or less, preferably 35 $\mu$m or less, more preferably 18 $\mu$m or less, and, for example, 4 $\mu$m or more. The thickness T1 of the first signal wire 34 is a thickness-direction length between one surface in the thickness direction of the first porous insulating layer 21 and one surface in the thickness direction of the first signal wire 34.
3.1.2 Two First Ground Wires 35
Each of the two first ground wires 35 makes an electrical connection with the earth to return a faint current that affects the first signal wire 34 back to the ground. The faint current includes a current of, for example, less than 1A, and less than 0.1A. The two first ground wires 35 are disposed at one side in the thickness direction of the two second penetrating holes 24, respectively. The two first ground wires 35 close one ends in the thickness direction of the two second penetrating holes 24, respectively. Each of the two first ground wires 35 is in contact with the one surface in the thickness direction of the first porous insulating layer 21 around each of the two second penetrating holes 24.

The two first ground wires 35 are separated from each other by an interval in the first direction. One of the first ground wires 35 is disposed at one side of the first signal wire 34 in the first direction, holding an interval therebetween. The other first ground wire 35 is disposed at the other side of the first signal wire 34 in the first direction, holding an interval therebetween. The other first ground wire 35 is disposed across the first signal wire 34 from the one first ground wire 35 in the first direction. In this manner, the one first ground wire 35, the first signal wire 34, and the other first ground wires 35 are arranged in the first direction, holding an interval therebetween. In other words, the first signal wire 34 is disposed between the two first ground wires 35.

At least one of the two first ground wires 35 includes a ground terminal 351. The ground terminal 351 is disposed at an end in the second direction of the first ground wire 35. The ground terminal 351 is connected to an earth member not illustrated.

Each of the two first ground wires 35 is thicker than the first signal wire 34.

When each of the two first ground wires 35 has the same thickness as that of the first signal wire 34, the press described blow drastically changes the thickness of the porous insulating layer 2 that overlaps the first signal wire 34 and the first ground wires 35 in the thickness direction, and thus drastically changes the electric properties of the first signal wire 34. Specifically, this causes a mismatch in the characteristic impedance of the first signal wire 34.

The two first ground wires 35 each have a thickness T2 of, for example, 6 $\mu$m or more, preferably 20 $\mu$m or more, more preferably 40 $\mu$m or more, and, for example, 52 $\mu$m or less. The thickness T2 of the first ground wire 35 is a thickness-direction between one surface in the thickness direction of the first porous insulating layer 21 and one surface in the thickness direction of the first ground wire 35.

A ratio (T2/T1) of the thickness T2 of the first ground wire 35 to the thickness T1 of the first signal wire 34 is more than 1, preferably 1.2 or more, more preferably 1.4 or more, even more preferably 1.6 or more. The upper limit of the ratio (T2/T1) of the thickness T2 of the first ground wire 35 to the thickness T1 of the first signal wire 34 is not limited. The upper limit of the ratio (T2/T1) is, for example, 13.

3.2 Second Conductive Layer 32

The second conductive layer 32 is disposed at the other side in the thickness direction of the first porous insulating layer 21. The second conductive layer 32 is disposed across the first porous insulating layer 21 from the first conductive layer 31 in the thickness direction. The second conductive layer 32 is disposed between the first porous insulating layer 21 and the second porous insulating layer 22 the thickness direction. The second conductive layer 32 is electrically connected to the first conductive layer 31. The second conductive layer 32 includes a second signal wire 36 and two second ground wires 37.

3.2.1 Second Signal Wire 36

The second signal wire 36 transmits the above-described signal, working together with the first signal wire 34 in the second direction. When being projected in the thickness direction, the second signal wire 36 overlaps the first signal wire 34. The second signal wire 36 is electrically connected to the first signal wire 34 in the thickness direction.

3.2.2 Two second ground wires 37

The two second ground wires 37 make an electrical connection with the earth to return a faint current that affects the first signal wire 34 and the second signal wire 36 back to the ground, working together with the two first ground wires 35. The two second ground wires 37 are disposed at one side and the other side in the first direction of the second signal wire 36, holding an interval therebetween. When being projected in the thickness direction, the second ground wire 37 overlaps the first ground wire 35.

Each of the two second ground wires 37 is the same as the second signal wire 36 in thickness.

3.3 Third Conductive Layer 33

The third conductive layer 33 is an example of a ground layer. In other words, the third conductive layer 33 makes an electrical connection with the earth to return a faint current that affects the first signal wire 34 and the second signal wire 36 back to the ground, working together with the first ground wire 35 and the second ground wire 37.

The third conductive layer 33 is disposed at the other side in the thickness direction of the second porous insulating layer 22. Specifically, the third conductive layer 33 is disposed on the other surface in the thickness direction of the second porous insulating layer 22. The third conductive layer 33 is disposed across the second porous insulating layer 22 from the second conductive layer 32 in the thickness direction. The third conductive layer 33 has a third ground portion 38 that exemplifies the third wiring portion and a fourth ground portion 39 that exemplifies the fourth wiring portion.

### 3.3.1 Third Ground Portion 38

The third ground portion 38 is disposed on the other surface in the thickness direction of the second porous insulating layer 22 between the two third penetrating holes 25. The third ground portion 38 extends in the first direction. When being projected in the thickness direction, the third ground portion 38 overlaps the first signal wire 34. When being projected in the thickness direction, the third ground portion 38 includes the first signal wire 34. Specifically, the third ground portion 38 includes an overlap portion 381 and a non-overlap portion 382. The overlap portion 381 overlaps the first signal wire 34. The non-overlap portion 382 does not overlap the first signal wire 34. In the embodiment, the overlap portion 381 is an intermediate portion in the first direction of the third ground portion 38. The non-overlap portions 382 extend outward from one end and the other end in the first direction of the overlap portion 381, respectively. The third ground portion 38 has a flat board shape.

The third ground portion 38 is thinner than the fourth ground portion 39 described next. Specifically, the third ground portion 38 has a thickness T3 of, for example, 50 $\mu$m or less, preferably 35 $\mu$m or less, more preferably 18 $\mu$m or less, and, for example, 4 $\mu$m or more. The thickness T3 of the third ground portion 38 is a thickness-direction length between the other surface in the thickness direction of the second porous insulating layer 22 and the other surface in the thickness direction of the third ground portion 38.

### 3.3.2 Fourth Ground Portion 39

The two fourth ground portions 39 are disposed at the other side in the thickness direction of the two third penetrating holes 25, respectively. The two fourth ground portions 39 close the other ends in the thickness direction of the two third penetrating holes 25, respectively. Each of the two fourth ground portions 39 is in contact with the other surface in the thickness direction of the second porous insulating layer 22 around each of the two third penetrating holes 25.

The two fourth ground portions 39 are separated by an interval in the first direction. Each of the two fourth ground portions 39 has a flat board shape. When being projected in the thickness direction, the fourth ground portions 39 overlap the first ground wires 35. A one-side part in the thickness direction of one of the fourth ground portions 39 is coupled to one end in the first direction of the third ground portion 38 (non-overlap portion 382). A one-side part in the thickness direction of the other fourth ground portion 39 is coupled to the other end in the first direction of the third ground portion 38 (overlap portion 382). In this manner, the two fourth ground portions 39 are electrically connected to each other via the third ground portion 38.

Each of the two fourth ground portions 39 is thicker than the third ground portion 38. Each of the two fourth ground portions 39 thicker than the third ground portion 38 can suppress a drastic change in the thickness of the porous insulating layer 2, which overlaps the third ground portion 38 and the fourth ground portions 39 in the thickness direction, by the press described below, and consequently can suppress a drastic change in the electric properties of the first signal wire 34 and second signal wire 36.

Each of the two fourth ground portions 39 has a thickness T4 of, for example, 6 $\mu$m or more, preferably 20 $\mu$m or more, more preferably 40 $\mu$m or more, and, for example, 52 $\mu$m or less. The thickness T4 of the fourth ground portion 39 is a thickness-direction between the other surface in the thickness direction of the second porous insulating layer 22 and the other surface in the thickness direction of the fourth ground portion 39.

A ratio (T4/T3) of the thickness T4 of the fourth ground portion 39 to the thickness T3 of the third ground portion 38 is more than 1, preferably 1.2 or more, more preferably 1.4 or more, even more preferably 1.6 or more. The upper limit of the ratio (T4/T3) of the thickness T4 of the fourth ground portion 39 to the thickness T3 of the third ground portion 38 is not limited. The upper limit of the ratio (T4/T3) is, for example, 13.

### 3.4 Material of Conductive Layer 3

The material of the conductive layer 3 is not limited. Examples of the material of the conductive layer 3 include copper, iron, silver, gold, aluminum, nickel, and alloys thereof (stainless steels and bronze). Preferably copper is used as the material of the conductive layer 3.

### 4. Conductor Connecting Portion 4

The conductor connecting portion 4 is disposed between the first conductive layer 31 and the second conductive layer 32 and between the second conductive layer 32 and the third conductive layer 33 in the thickness direction. The conductor connecting portion 4 is disposed in the first penetrating hole 23, the second penetrating holes 24, and the third penetrating holes 25. The conductor connecting portion 4 has a first conductor connecting portion 41, two second conductor connecting portions 42, and two third conductor connecting portions 43.

4.1 First Conductor Connecting Portion 41

A part (major part) of the first conductor connecting portion 41 fills the first penetrating hole 23, and the remaining part (the other end in the thickness direction) of the first conductor connecting portion 41 protrudes from the first penetrating hole 23 toward the other side in the thickness direction. One end in the thickness direction of the first conductor connecting portion 41 is in contact with (continues to) the first signal wire 34. The other end in the thickness direction of the first conductor connecting portion 41 is in contact with the second signal wire 36. In this manner, the first signal wire 34 and the second signal wire 36 are electrically connected to each other via the first conductor connecting portion 41. Consequently, the first signal wire 34, the second signal wire 36, and the first conductor connecting portion 41 form an approximately I-shaped signal path in the cross-sectional view. The signal path extends in the thickness direction and the second direction.

4.2 Second Conductor Connecting Portion 42

A part (major part) of each of the second conductor connecting portions 42 fills each of the second penetrating holes 24, and the remaining part (the other end in the thickness direction) of each of the second conductor connecting portions 42 protrudes from the second penetrating hole 24 toward the other side in the thickness direction. One end in the thickness direction of each of the second conductor connecting portions 42 is in contact with (continues to) each of the first ground wires 35. The other end in the thickness direction of each of the second conductor connecting portions 42 is contact with each of the second ground wires 37. In this manner, the first ground wires 35 and the second ground wires 37 are electrically connected to each other via the second conductor connecting portions 42.

4.3 Third Conductor Connecting Portion 43

A part (major part) of each of the third conductor connecting portions 43 fills each of the third penetrating holes 25, the remaining part (one end in the thickness direction) of each of the third conductor connecting portions 43 protrudes from each of the third penetrating holes 25 toward one side in the thickness direction. The other end in the thickness direction of each of the third conductor connecting portions 43 is in contact with (continues to) each of the fourth ground portions 39. One end in the thickness direction of each of the third conductor connecting portions 43 is in contact with each of the second ground wires 37. In this manner, the second ground wires 37 and the third conductive layer 33 are electrically connected to each other via the third conductor connecting portions 43.

As described above, the first ground wires 35, the second ground wires 37, the third conductive layer 33, the second conductor connecting portions 42, and the third conductor connecting portions 43 form an approximately U-shaped ground path in the cross-sectional view. The ground path opens toward one side in the thickness direction in the cross-sectional view.

4.4 Material of Conductor Connecting Portion 4

The material of the conductor connecting portion 4 is the same as the above-described material of the conductive layer 3.

5. Insulating Cover Layer 5

The insulating cover layer 5 is disposed at one side and the other side in the thickness direction of the conductive layer 3. The insulating cover layer 5 has a first insulating cover layer 51 and a second insulating cover layer 52.

5.1 First Insulating Cover Layer 51

The first insulating cover layer 51 is disposed at one side of the first conductive layer 31 in the thickness direction. The first insulating cover layer 51 forms one surface in the thickness direction of the wiring circuit board 1. The first insulating cover layer 51 exposes the signal terminal 341 and the ground terminal 351. The first insulating cover layer 51 covers the first conductive layer 31 other than the signal terminal 341 and the ground terminal 351.

5.2 Second Insulating Cover layer 52

The second insulating cover layer 52 is disposed at the other side of the third conductive layer 33 in the thickness direction. The second insulating cover layer 52 forms the other surface in the thickness direction of the wiring circuit board 1. The second insulating cover layer 52 covers the third conductive layer 33.

### 5.3 Material of Insulating Cover Layer 5

Examples of the material of the insulating cover layer 5 include the resins cited above.

### 6. Adhesive Layer 6

The adhesive layer 6 is disposed between the above-described layers. The material (or raw material) of the adhesive layer 6 is not limited. The adhesive layer 6 includes a first adhesive layer 61, a second adhesive layer 62, and a third adhesive layer 63 toward the other side in the thickness direction.

### 6.1 First Adhesive Layer 61

The first adhesive layer 61 is disposed at one surfaces in the thickness direction of the first conductive layer 31 and first porous insulating layer 21, and the other surface in the thickness direction of the first insulating cover layer 51. The first adhesive layer 61 bonds the first conductive layer 31 and first porous insulating layer 21 to the first insulating cover layer 51. The first adhesive layer 61 is in contact with one surfaces and side surfaces in the thickness direction of the first conductive layer 31, and one surface in the thickness direction of the first porous insulating layer 21 around the first conductive layer 31. The first adhesive layer 61 is in contact with the other surface in the thickness direction of the first insulating cover layer 51.

### 6.2 Second Adhesive Layer 62

The second adhesive layer 62 is disposed at the other surface in the thickness direction of the first porous insulating layer 21 and one surface in the thickness direction of the second porous insulating layer 22. In other words, the second adhesive layer 62 is disposed between the first porous insulating layer 21 and the second porous insulating layer 22. The second adhesive layer 62 embeds the second conductive layer 32 in the thickness direction. Specifically, the second adhesive layer 62 is in contact with both surfaces in the thickness direction of the second conductive layer 32 and side surfaces in the thickness direction of the second conductive layer 32. The second adhesive layer 62 is in contact with the side surfaces of the above-described remaining parts of the conductor connecting portion 4. Specifically, the second adhesive layer 62 is in contact with a peripheral side surface of the other end in the thickness direction of the first conductor connecting portion 41, a peripheral side surface of the other end in the thickness direction of the second conductor connecting portion 42, and a peripheral side surface of one end in the thickness direction of the third conductor connecting portion 43.

### 6.3 Third Adhesive Layer 63

The third adhesive layer 63 is disposed on the other surface in the thickness direction of the third conductive layer 33, the other surface in the thickness direction of the second porous insulating layer 22, and one surface in the thickness direction of the second insulating cover layer 52. FIG. 1 does not illustrate a mode in which the third adhesive layer 63 is disposed on the other surface in the thickness direction of the second porous insulating layer 22. The third adhesive layer 63 bonds the third conductive layer 33 and second porous insulating layer 22 to the second insulating cover layer 52. The third adhesive layer 63 is in contact with the other surface in the thickness direction of the third conductive layer 33 and side surfaces in the thickness direction of the third conductive layer 33, and the other surface in the thickness direction of the second porous insulating layer 22 around the third conductive layer 33.

### 7. Fourth Adhesive Layer 64 and Reinforcement Layer 7

The wiring circuit board 1 may include a fourth adhesive layer 64 and a reinforcement layer 7, both of which are illustrated by the phantom lines.

The fourth adhesive layer 64 is disposed on the other surface in the thickness direction of the second insulating cover layer 52. The fourth adhesive layer 64 bonds the second insulating cover layer 52 to the reinforcement layer 7 described next.

The reinforcement layer 7 reinforces the first signal wire 34 and the third ground portion 38. The reinforcement layer 7 is disposed at the other side in the thickness direction of the second insulating cover layer 52. Specifically, the reinforcement layer 7 is bonded to the other surface in the thickness direction of the second insulating cover layer 52 via the fourth adhesive layer 64. When being projected in the thickness direction, the reinforcement layer 7 overlaps the first signal wire 34 and the third ground portion 38. The reinforcement layer 7 has a flat board shape. The material of the reinforcement layer 7 is not limited. Examples of the material of the reinforcement layer 7 include metals and hard resins. Preferable examples of the material of the reinforcement layer 7 include metals, specifically, stainless-steel, copper, iron, and aluminum. The thickness of the reinforcement layer 7 is not limited.

8. Method of Producing Wiring Circuit Board 1

Next, the method of producing the wiring circuit board 1 is described with reference to FIG. 1 to FIG. 4B.

8.1 Preparation of First Porous Laminate 81

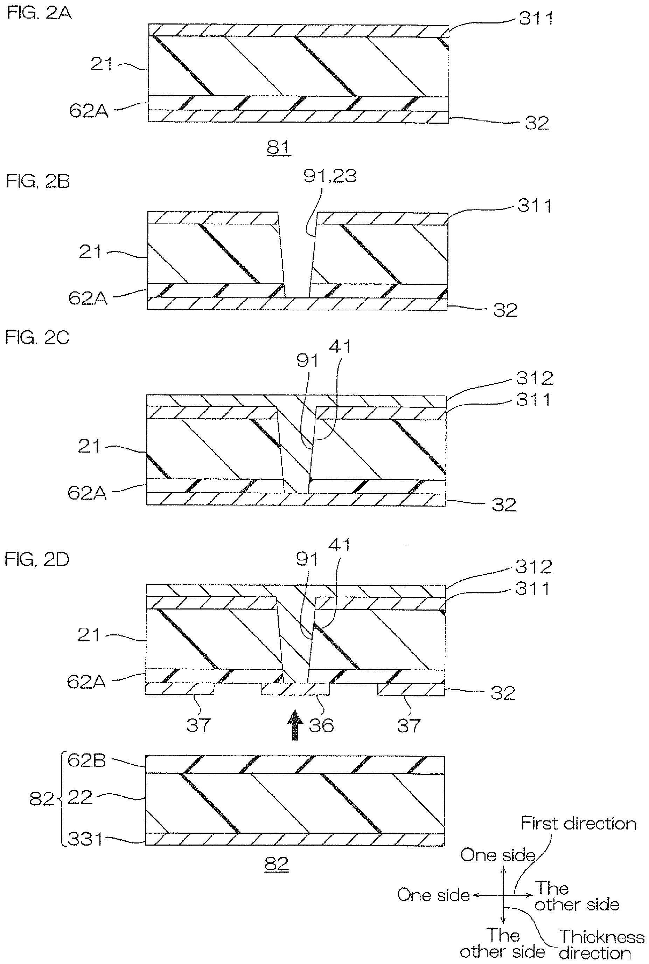

As illustrated in FIG. 2A, a first porous laminate 81 is prepared first in the method.
The first porous laminate 81 includes a second conductive layer 32, a one-side second adhesive layer 62A, the first porous insulating layer 21, and a first underlying layer 311 toward one side in the thickness direction.
The second conductive layer 32 is disposed at the other side in the thickness direction of the first porous insulating layer 21 in the first porous laminate 81. The second conductive layer 32 of the first porous laminate 81 is yet to be patterned, and is not the second conductive layer 32 of the wiring circuit board 1 illustrated in FIG. 1.
The one-side second adhesive layer 62A is disposed on one surface in the thickness direction of the second conductive layer 32 and the other surface in the thickness direction of the first porous insulating layer 21.
The first underlying layer 311 is disposed on one surface in the thickness direction of the first porous insulating layer 21. The first underlying layer 311 is included in the first conductive layer 31 of the wiring circuit board 1 illustrated in FIG. 1.
A method of preparing the first porous laminate 81 is described in, for example, Japanese Unexamined Patent Publication No. 2019-123851.

8.2 Formation of First Via 91

As illustrated in FIG. 2B, next, a first via 91 is formed in the first underlying layer 311, the first porous insulating layer 21, and the one-side second adhesive layer 62A. The first via 91 formed in the first porous insulating layer 21 is the above-described first penetrating hole 23.
Examples of a method of forming the first via 91 include a piercing process. Examples of the piercing process include a laser process, a drilling process, and a blasting method. Preferably, a laser process is used.

8.3 Formation of First Plated Layer 312

As illustrated in FIG. 2C, next, the first plated layer 312 is formed on an inner peripheral surface of the first via 91 and one surface in the thickness direction of the first underlying layer 311. The first plated layer 312 formed on the inner peripheral surface of the first via 91 is the above-described first conductor connecting portion 41.

8.4 Patterning of Second Conductive Layer 32

As illustrated in FIG. 2D, the second conductive layer 32 is patterned to form the second signal wire 36 and the two second ground wires 37. Examples of the patterning of the second conductive layer 32 include wet etching and dry etching. Preferably wet etching is used.

8.5 Bonding Second Porous Laminate 82 to Second Conductive Layer 32

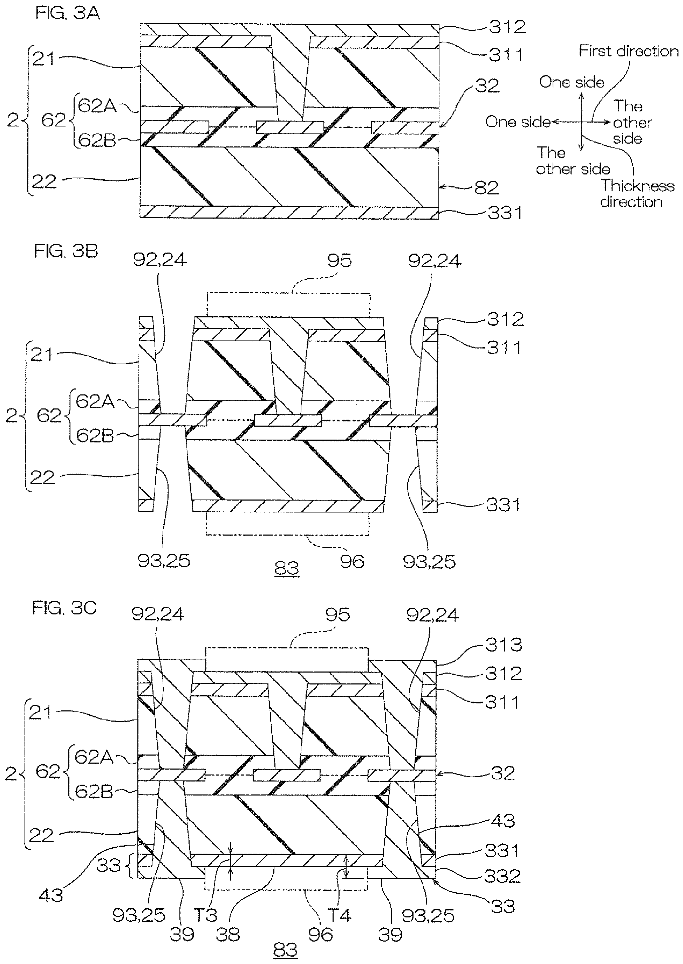

As illustrated by the lower part of FIG. 2D and FIG. 3A, the second porous laminate 82 is bonded to the second conductive layer 32.
As illustrated by the lower part of FIG. 2D, the second porous laminate 82 is prepared first. The second porous laminate 82 includes the other-side second adhesive layer 62B, the second porous insulating layer 22, and a second underlying layer 331 sequentially toward the other side in the thickness direction.
The other-side second adhesive layer 62B is disposed on one surface in the thickness direction of the second porous insulating layer 22.
The second underlying layer 331 is disposed on the other surface in the thickness direction of the second porous insulating layer 22. The second underlying layer 331 is included in the third conductive layer 33.
A method of preparing the second porous laminate 82 is described in, for example, Japanese Unexamined Patent Publication No. 2019-123851.

As illustrated by the arrow of FIG. 2D and FIG. 3A, next, the other-side second adhesive layer 62B of the second porous laminate 82 is bonded to the second conductive layer 32. At the time, a press machine (not illustrated) that can carry out the press in the thickness direction is used. The pressure of the press is not limited. The pressure of the press is, for example, 0.5 MPa or more, preferably 3 MPa or more, and, for example, 10 MPa or less. The press is carried out for a time of, for example, 1 minute or more, preferably 10 minutes or more, and, for example, 120 minutes or less. The press may be a hot press. The press is carried out at a temperature of, for example, 80°C or more, preferably 120°C or more, and, for example, 300°C or less.

During the above-mentioned bonding of the other-side second adhesive layer 62B, the one-side second adhesive layer 62A and the other-side second adhesive layer 62B are deformed and enter between the adjacent second signal wire 36 and second ground wires 37. In this manner, the one-side second adhesive layer 62A and the other-side second adhesive layer 62B form the second adhesive layer 62. The phantom lines of FIG. 3A to FIG. 4B each illustrate the boundary between the one-side second adhesive layer 62A and the other-side second adhesive layer 62B. However, the boundary may not be observed. The one-side second adhesive layer 62A and the other-side second adhesive layer 62B are integrated.

8.6 Formation of Second Via 92 and Third Via 93

As illustrated in FIG. 3B, a second via 92 is formed in the first plated layer 312, the first underlying layer 311, and the one-side second adhesive layer 62A. The second vias 92 formed in the first porous insulating layer 21 are the second penetrating holes 24.

In addition, a third via 93 is formed in the second underlying layer 331, the second porous insulating layer 22, and the other-side second adhesive layer 62B. The third vias 93 formed in the second porous insulating layer 22 are the third penetrating holes 25.

Examples of a method of forming the second vias 92 and the third vias 93 include the method cited as the method of forming the first via 91.

8.7 Formation of Second Plated Layer 313 and Third Plated Layer 332

As illustrated in FIG. 3C, next, a second plated layer 313 is formed on one surface in the thickness direction of the first plated layer 312 and an inner peripheral surface of the second via 92. In addition, a third plated layer 332 is formed on the other surface in the thickness direction of the second underlying layer 331 and an inner peripheral surface of the third via 93.

Specifically, before the formation of the second plated layer 313 and the third plated layer 332, as illustrated in FIG. 3B, a first resist 95 and a second resist 96 are disposed on one surface in the thickness direction of the first plated layer 312 and the other surface in the thickness direction of the second underlying layer 331, respectively. The first resist 95 and the second resist 96 are resists for plating. The first resist 95 has a reverse pattern of the second plated layer 313. The second resist 96 has a reverse pattern of the third plated layer 332.

Thereafter, a plating process is carried out by immersing a resist laminate 83 including the first plated layer 312 and the second underlying layer 331 in a plating bath, while the first resist 95 is disposed on the first plated layer 312 and the second resist 96 is disposed on the second underlying layer 331.

The second plated layer 313 is deposited on one surface in the thickness direction of the first plated layer 312 that is exposed from the first resist 95, and on the inner peripheral surface of the second via 92. On the other hand, the second plated layer 313 is not deposited on one surface in the thickness direction of the first plated layer 312 on which the first resist 95 is disposed.

The third plated layer 332 is deposited on the other surface in the thickness direction of the second underlying layer 331 that is exposed from the second resist 96, and on the inner peripheral surface of the third via 93. On the other hand, the third plated layer 332 is not deposited on the other surface in the thickness direction of the second underlying layer 331 on which the second resist 96 is disposed.

In this manner, the third conductive layer 33 including the third ground portion 38 and the fourth ground portions 39 is formed.

The third ground portion 38 is formed from the second underlying layer 331. Thus, the thickness T3 of the third ground portion 38 is the same as that of the second underlying layer 331.

The fourth ground portion 39 is formed from the second underlying layer 331 and the third plated layer 332. Thus, the thickness T4 of each of the fourth ground portions 39 is the same as the total thickness of the second underlying layer 331 and the third plated layer 332.

Thereafter, the first resist 95 and the second resist 96 are removed.

8.8 Patterning of First Plated Layer 312 and First Underlying Layer 311

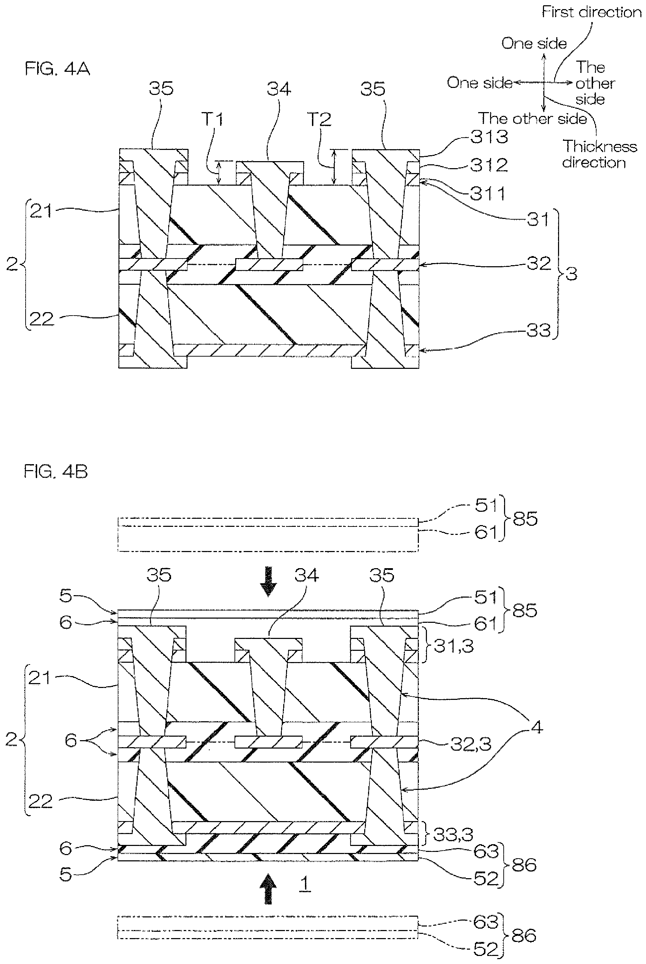

As illustrated in FIG. 4A, the first plated layer 312 and the first underlying layer 311 are patterned. Examples of the patterning of the first plated layer 312 and the first underlying layer 311 include wet etching and dry etching. Preferably, wet etching is used. In this manner, the first conductive layer 31 including the first signal wire 34 and the first ground wire 35 is formed (implementation of the first step).

The first signal wire 34 is formed from the patterned first underlying layer 311 and the patterned first plated layer 312. Thus, the thickness T1 of the first signal wire 34 is the total thickness of the first underlying layer 311 and the first plated layer 312.

The first ground wire 35 is formed from the patterned first underlying layer 311, the patterned first plated layer 312, and the patterned second plated layer 313. Thus, the thickness T2 of the first ground wire 35 is the total thickness of the first underlying layer 311, the first plated layer 312, and the second plated layer 313.

8.9 Bonding of First Cover Laminate 85 and Second Cover Laminate 86

As illustrated in FIG. 4B, a first cover laminate 85 is bonded to the first conductive layer 31 (implementation of the second step). As illustrated by the phantom lines, the first cover laminate 85 includes the first insulating cover layer 51 and the first adhesive layer 61 sequentially toward the other side in the thickness direction.

In addition, a second cover laminate 86 is bonded to the third conductive layer 63. As illustrated by the phantom lines, the second cover laminate 86 includes the second insulating cover layer 52 and the third adhesive layer 63 sequentially toward one side in the thickness direction.

The above-described press machine is used for the bonding. The conditions for the press are the same as described above.

During the bonding of the first cover laminate 85, the first adhesive layer 61 enters between the adjacent first signal wire 34 and first ground wires 35. The first adhesive layer 61 is in contact with one surface in the thickness direction of the first porous insulating layer 21 exposed from the first signal wire 34 and the first ground wire 35.

During the bonding of the second cover laminate 86, the second adhesive layer 62 is brought into contact with the other surface in the thickness direction of the second porous insulating layer 22 around the third conductive layer 33.

As described above, the wiring circuit board 1, which includes the porous insulating layer 2, the conductive layer 3, the conductor connecting portion 4, the insulating cover layer 5, and the adhesive layer 6, is produced.

When the wiring circuit board 1 is provided with the reinforcement layer 7 as illustrated in FIG. 1, the reinforcement layer 7 is bonded to the second insulating cover layer 52 via the fourth adhesive layer 64. The above-described press machine is used for the bonding of the reinforcement layer 7. The conditions for the press are the same as describe above.

9. Operations and Effects of One Embodiment

The wiring circuit board 1 includes the first ground wires 35 each thicker than the first signal wire 34. In other words, the first signal wire 34 is thinner than each of the first ground wires 35.

Thus, for example, when the second porous laminate 82 is bonded to the second conductive layer 32 (see FIG. 2D), and further, when the reinforcement layer 7 is provided to the wiring circuit board 1, the pressing of the first porous insulating layer 21 in the thickness direction applies a lower pressure on the first porous insulating layer 21 that overlaps the first signal wire 34 in the thickness direction than on the first porous insulating layer 21 that overlaps the first ground wires 35 in the thickness direction. Thus, the change in the thickness of the first porous insulating layer 21 that overlaps the first signal wire 34 in the thickness direction is suppressed more than the change in the thickness of the first porous insulating layer 21 that overlaps the first ground wires (second wiring portions) 35 in the thickness direction. Specifically, the mismatch in the characteristic impedance of the first signal wire 34 can be suppressed.

As a result, the change in the electric properties of the first signal wire 34 is suppressed more than the change in the electric properties of the first ground wires 35.

On the other hand, the first porous insulating layer 21 that overlaps the first ground wires 35 drastically changes. However, the faint current flowing through the first ground wire 35 is returned back to the ground by the electrical connection with the earth. This allows a large change in the electric properties of the first ground wires 35.

In the wiring circuit board 1, the third conductive layer 33, which is a ground layer, includes the third ground portion 38, which overlaps the first signal wire 34, and the fourth ground portion 39, which overlaps the first ground wire 35 and is thicker than the third ground portion 38. Thus, when the wiring circuit board 1 is pressed in the thickness direction, the porous insulating layer 2 (the first porous insulating layer 21 and second porous insulating layer 22) that overlaps the first signal wire 34 in the thickness direction receives a lower pressure than the porous insulating layer 2 that overlaps the first ground wires 35 in the thickness direction does. This can suppress the change in the thickness of the porous insulating layer 2 that overlaps the first signal wire 34 in the thickness direction more than the change in the thickness of the porous insulating layer 2 that overlaps the first ground wires 35 in the thickness direction. Specifically, the mismatch in the characteristic impedance of the first signal wire 34 can be suppressed better.

Even when a high pressure is applied on the porous insulating layer 2 (the first porous insulating layer 21 and second porous insulating layer 22) in the step of bonding the first cover laminate 85 to the first conductive layer 31 as described in FIG. 4B in the production method, the change in the thickness of the porous insulating layer 2 that overlaps the first signal wire 34 in the thickness direction is suppressed more than the change in the thickness of the porous insulating layer 2 that overlaps the first ground wires 35 in the thickness direction as described above. As a result, the change in the electric properties of the first signal wire 34 can be suppressed more than the change in the electric properties of the first ground wires 35.

10. Variations

In each of the variations, the same members and steps as in one embodiment will be given the same numerical references and the detailed description thereof will be omitted. Further, the variations can have the same operations and effects as those of one embodiment unless especially described otherwise. Furthermore, one embodiment and the variations can appropriately be combined.

The first ground wire 35, the second ground wire 37, and the third conductive layer 33 may be a first power wire, a second power wire, and a power layer, respectively. The first power wire, the second power wire, and the power layer form a power path together with the second conductor connecting portion 42 and the third conductor connecting portion 43. A large current, for example, 1A or more or 10A or more flows through the power path.

As illustrated in FIG. 1, the first signal wire 34 is disposed between the two first ground wires 35. Although not illustrated, a variation may include a first signal wire 34 disposed across one of the first ground wires 35 from the other first ground wire 35 in the first direction. Alternatively, the first signal wire 34 may be disposed across the other first ground wire 35 from the one first ground wire 35 in the first direction.

Preferably, the first signal wire 34 is disposed between the two first ground wires 35. In such a disposition, the porous insulating layer 2 that overlaps the two first ground wires 35 in the thickness direction can receive the high pressure while keeping the balance between the pressures on the two overlapping parts during the press using a flat board-shaped pressing plate. Thus, the porous insulating layer 2 that overlaps the first signal wire 34 disposed between the two first ground wires 35 receives a lower pressure. This can suppress the change in the thickness of the porous insulating layer 2 that overlaps the first signal wire 34 in the thickness direction more than the change in the thickness of the porous insulating layer 2 that overlaps the first ground wires 35 in the thickness direction.

Although not illustrated, one first ground wire (second wiring portion) 35 may be provided.

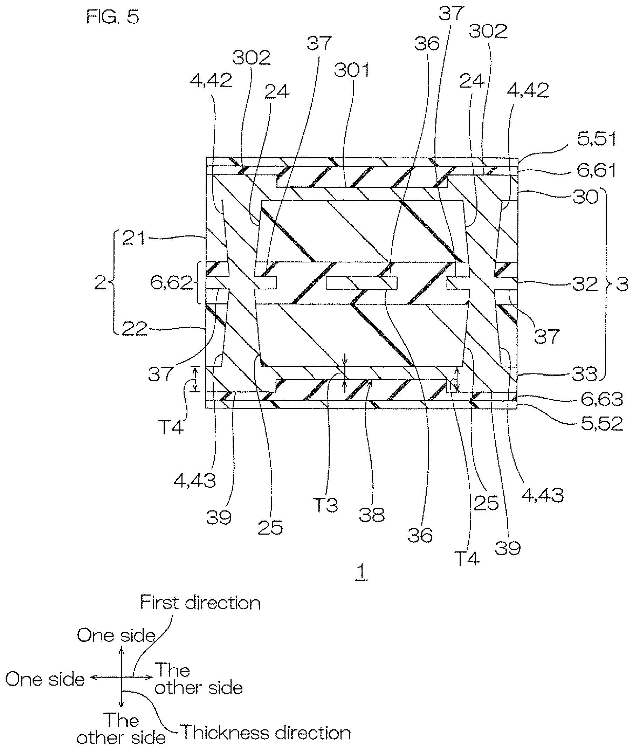

In the wiring circuit board 1 illustrated in FIG. 5, the conductive layer 3 has a first conductive layer 30 that exemplifies a ground layer. The first conductive layer 30 is disposed on one surface in the thickness direction of the first porous insulating layer 21. The first conductive layer 30 includes a first ground portion 301 and a second ground portion 302.

The first ground portion 301 is disposed on one surface in the thickness direction of the first porous insulating layer 21 between the two second penetrating holes 24. The first ground portion 301 extends in the first direction. When being projected in the thickness direction, the first ground portion 301 overlaps the third ground portion 38. The first ground portion 301 has a flat board shape.

The other-side part in the thickness direction of one of the second ground portions 302 is coupled to one end in the first direction of the first ground portion 301. The other-side part in the thickness direction of the other second ground portion 302 is coupled to the other end in the first direction of the first ground portion 301. In this manner, the two second ground portions 302 are electrically connected to each other via the first ground portion 301.

Hence, the first conductive layer 30, the second ground wires 37, the third conductive layer 33, and the conductor connecting portion 4 form a ground path having an approximately rectangular frame shape in the cross-sectional view. The rectangular frame surrounds the second signal wire 36 in the cross-sectional view.

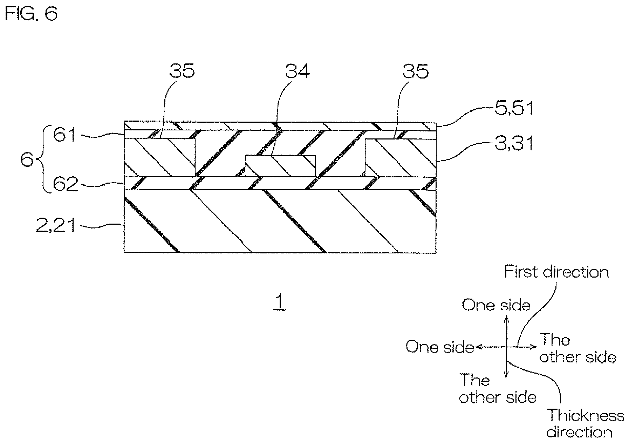

As illustrated in FIG. 6, the wiring circuit board 1 includes one porous insulating layer 2, one conductive layer 3, two adhesive layers 6, and one insulating cover layer 5.

The porous insulating layer 2 is the first porous insulating layer 21. The first porous insulating layer 21 does not include the second penetrating holes 24.

The conductive layer 3 is the first conductive layer 31.

The adhesive layers 6 include the first adhesive layer 61 and the second adhesive layer 62.

The insulating cover layer 5 is the first insulating cover layer 51.

In the wiring circuit board 1 illustrated in FIG. 6, the first porous insulating layer 21, the second adhesive layer 62, the first conductive layer 31, the first adhesive layer 61, and the first insulating cover layer 51 are disposed sequentially toward one side in the thickness direction.

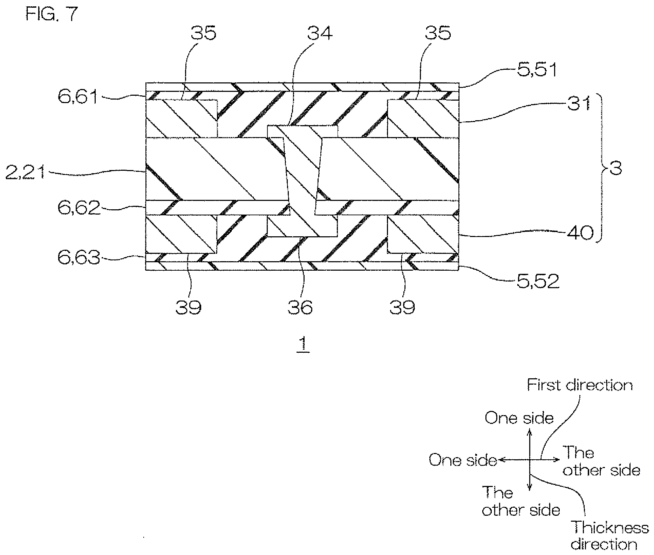

In the wiring circuit board 1 illustrated in FIG. 7, the conductive layer 3 includes the first conductive layer 31 and a third conductive layer 40.

The third conductive layer 40 includes the second signal wire 36 and the two fourth ground portions 39.

Although not illustrated, the porous insulating layer 2 includes a skin layer on one end and/or the other end in the thickness direction of the porous insulating layer 2. The skin layer extends in the surface direction. The skin layer is flat and smooth. For example, the first porous insulating layer 21 includes a skin layer disposed on one end and/or the other end in the thickness direction of the first porous insulating layer 21. The second porous insulating layer 22 includes a skin layer on one end and/or the other end in the thickness direction of the second porous insulating layer 22.

The skin layer located on one end of the first porous insulating layer 21 in the thickness direction forms one surface of the first porous insulating layer 21 in the thickness direction. The skin layer located on the other end of the first porous insulating layer 21 in the thickness direction forms the other surface of the first porous insulating layer 21 in the thickness direction. A ratio of the thickness of each of the skin layers to the thickness of the first porous insulating layer 21 is, for example, less than 0.1. The thickness of each of the skin layers is appropriately adjusted to ensure the peel strength of the skin layer from the first underlying layer 311. Specifically, the skin layers each have a thickness, for example, 1 $\mu$m or more, and, for example, 50 $\mu$m or less, preferably, 30 $\mu$m or less.

The skin layer located on one end of the second porous insulating layer 22 in the thickness direction forms one surface of the second porous insulating layer 22 in the thickness direction. The skin layer located on the other end of the second porous insulating layer 22 in the thickness direction forms the other surface of the second porous insulating layer 22 in the thickness direction. A ratio of the thickness of each of the skin layers to the thickness of the second porous insulating layer 22 is, for example, less than 0.1. The thickness of each of the skin layers is appropriately adjusted to ensure the peel strength of the skin layer from the other-side second adhesive layer 62B. Specifically, the skin layers each have a thickness of, for example, 1 $\mu$m or more, and, for example, 50 $\mu$m or less, preferably, 30 $\mu$m or less.

Although not illustrated, the adhesive layer 6 includes a fourth adhesive layer and a fifth adhesive layer, both of which are not illustrated.

The fourth adhesive layer is disposed on one surface in the thickness direction of the first porous insulating layer 21. The fourth adhesive layer intervenes between the first porous insulating layer 21 and the first conductive layer 31. The fourth adhesive layer bonds the first porous insulating layer 21 to the first conductive layer 31. In this variation, the fourth adhesive layer and the second adhesive layer 62 (the one-side second adhesive layer 62A, see FIG. 3C) are disposed on one surface and the other surface in the thickness direction of the first porous insulating layer 21, respectively.

The fifth adhesive layer is disposed on the other surface in the thickness direction of the second porous insulating layer 22. The fifth adhesive layer intervenes between the second porous insulating layer 22 and the third conductive layer 33. The fifth adhesive layer bonds the second porous insulating layer 22 to the third conductive layer 33. In this variation, the second adhesive layer 62 (the other-side second adhesive layer 62B, see FIG. 3C) and the fifth adhesive layer are disposed on one surface and the other surface in the thickness direction of the second porous insulating layer 22, respectively.

To produce the wiring circuit board 1 of this variation, a first porous laminate 81, which includes a second conductive layer 32, a one-side second adhesive layer 62A, a first porous insulating layer 21, a fourth adhesive layer not illustrated, and a first underlying layer 311 sequentially toward one side in the thickness direction as illustrated in FIG. 2A, is prepared.

A second porous laminate 82, which includes the other-side second adhesive layer 62B, a second porous insulating layer 22, a fifth adhesive layer not illustrated, and a second underlying layer 331 sequentially toward the other side in the thickness direction as illustrated in the lower part of FIG. 2D, is used.

While the illustrative embodiments of the present invention are provided in the above description, such is for illustrative purpose only and it is not to be construed as limiting in any manner. Modification and variation of the present invention that will be obvious to those skilled in the art is to be covered by the following claims.

Description of Reference Numerals

| 1 | wiring circuit board |
|---|---|
| 2 | porous insulating layer |
| 3 | conductive layer |
| 4 | conductor connecting portion |
| 5 | insulating cover layer |
| 21 | first porous insulating layer |
| 22 | second porous insulating layer |
| 23 | first penetrating hole |
| 24 | second penetrating hole |

| 25 | third penetrating hole |
|---|---|
| 30, 31 | first conductive layer |
| 32 | second conductive layer |
| 33, 40 | third conductive layer (ground layer) |
| 34 | first signal wire (first wiring portion) |
| 35 | first ground wire (second wiring portion) |
| 36 | second signal wire |
| 37 | second ground wire |
| 38 | third ground portion (third wiring portion) |
| 39 | fourth ground portion (fourth wiring portion) |
| 51 | first insulating cover layer |
| 52 | second insulating cover layer |

**Claims**

1. A wiring circuit board comprising a porous insulating layer and a conductive layer sequentially toward one side in a thickness direction, wherein the conductive layer has a first wiring portion and a second wiring portion thicker than the first wiring portion.

2. The wiring circuit board according to Claim 1, wherein

   two of the second wiring portions are disposed and separated from each other by an interval in a direction orthogonal to the thickness direction, and
   the first wiring portion is disposed between the second wiring portions.

3. The wiring circuit board according to Claim 1 or 2, further comprising a ground layer disposed on the other surface in the thickness direction of the porous insulating layer, wherein

   the ground layer has a third wiring portion and a fourth wiring portion, the third wiring portion overlaps the first wiring portion and the fourth wiring portion overlaps the second wiring portion when being projected in the thickness direction, and
   the fourth wiring portion is thicker than the third wiring portion.

4. The wiring circuit board according to Claim 3, wherein

   the porous insulating layer has a penetrating hole penetrating the porous insulating layer in the thickness direction, and
   the wiring circuit board further comprises a conductor connecting portion filling the penetrating hole and being in contact with the conductive layer and the ground layer.

5. The wiring circuit board according to any one of Claims 1 to 4, further comprising:

   an adhesive layer; and
   an insulating cover layer, wherein
   the insulating cover layer covers the conductive layer and the porous insulating layer through the adhesive layer from one side in the thickness direction.

6. A method of producing a wiring circuit board, the method comprising:

   a first step of disposing a conductive layer on one surface in a thickness direction of a porous insulating layer, wherein the conductive layer includes a first wiring portion and a second wiring portion thicker than the first wiring portion; and
   a second step of pressing the insulating cover layer through an adhesive layer to the conductive layer and the porous insulating layer.

FIG. 1

First direction

One side

One side ← → The other side

The other side — Thickness direction

FIG. 2A

311

21

62A

32

81

FIG. 2B

91,23

311

21

62A

32

FIG. 2C

91   41

312
311

21

62A

32

FIG. 2D

91   41

312
311

21

62A

32

37      36      37

62B

82   22

331

82

First direction

One side

One side ← → The
other side

The          Thickness
other side    direction

FIG. 3A

312
311
21
32
2
62 { 62A
62B
22
82
331

First direction
One side
One side ←→ The other side
The other side
Thickness direction

FIG. 3B

92,24    95    92,24

21
312
311
2
62 { 62A
62B
22

331
93,25    83    96    93,25

FIG. 3C

92,24    95    92,24

313
312
311
21
2
62 { 62A
62B
32
22
43
331
332
33 {
43    33
93,25    T3    T4    93,25
39    38    96    39
83

FIG. 4A

FIG. 4B

FIG. 5

First direction

One side

One side ← → The other side

The other side — Thickness direction

1

FIG. 6

1

First direction
One side
One side ← → The other side
The other side
Thickness direction

FIG. 7

1

First direction

One side

One side ← → The other side

The other side

Thickness direction

Europäisches
Patentamt

European
Patent Office

Office européen
des brevets

# EUROPEAN SEARCH REPORT

Application Number

EP 22 17 4581

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | JP 2000 101245 A (NGK SPARK PLUG CO) 7 April 2000 (2000-04-07) | 1,2,5,6 | INV. H05K1/03 |
| Y | * paragraphs [0024] – [0028]; figures 1,2,3a * | 3,4 | H05K1/11 H05K3/46 |
| | ----- | | |
| X | US 4 490 690 A (SUZUKI HIROSUKE [JP]) 25 December 1984 (1984-12-25) * column 1, lines 48-51; figure 3 * * column 2, lines 53-64 * | 1,2,5,6 | ADD. H05K3/00 H05K3/18 H05K3/42 |
| | ----- | | |
| Y | US 2018/309182 A1 (IIDA KANTO [JP] ET AL) 25 October 2018 (2018-10-25) * paragraphs [0101] – [0110]; figure 11 * | 3,4 | |
| | ----- | | |

**TECHNICAL FIELDS SEARCHED       (IPC)**

H05K

The present search report has been drawn up for all claims

| Place of search | Date of completion of the search | Examiner |
|---|---|---|
| The Hague | 19 October 2022 | Tomezak, Alexandre |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons
..............................................................................................
& : member of the same patent family, corresponding
    document

EPO FORM 1503 03.82 (P04C01)

## ANNEX TO THE EUROPEAN SEARCH REPORT
## ON EUROPEAN PATENT APPLICATION NO.

EP 22 17 4581

This annex lists the patent family members relating to the patent documents cited in the above-mentioned European search report.
The members are as contained in the European Patent Office EDP file on
The European Patent Office is in no way liable for these particulars which are merely given for the purpose of information.

19-10-2022

| Patent document cited in search report | | Publication date | Patent family member(s) | | Publication date |
|---|---|---|---|---|---|
| JP 2000101245 | A | 07-04-2000 | JP 2000101245 A | | 07-04-2000 |
| | | | US 6323439 B1 | | 27-11-2001 |
| US 4490690 | A | 25-12-1984 | NONE | | |
| US 2018309182 | A1 | 25-10-2018 | CN 208608339 U | | 15-03-2019 |
| | | | JP 6330977 B2 | | 30-05-2018 |
| | | | JP 6489265 B2 | | 27-03-2019 |
| | | | JP 6690746 B2 | | 28-04-2020 |
| | | | JP 6891997 B2 | | 18-06-2021 |
| | | | JP 2018121076 A | | 02-08-2018 |
| | | | JP 2019071696 A | | 09-05-2019 |
| | | | JP 2020141406 A | | 03-09-2020 |
| | | | JP WO2017130731 A1 | | 07-06-2018 |
| | | | US 2018309182 A1 | | 25-10-2018 |
| | | | US 2020235451 A1 | | 23-07-2020 |
| | | | US 2022131250 A1 | | 28-04-2022 |
| | | | WO 2017130731 A1 | | 03-08-2017 |

EPO FORM P0459

For more details about this annex : see Official Journal of the European Patent Office, No. 12/82

**EP 4 096 370 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2019123851 A